# EUROPEAN PATENT APPLICATION

(11) **EP 2 381 465 A1**
(43) Date of publication of application: **26.10.2011**
(21) Application number: 10160809.9
(22) Date of filing: 22.04.2010
(51) Int. Cl.: H01L 21/00, H01L 21/683

(54) **Tool tip interface for a die handling tool**

(71) Applicant: Kulicke & Soffa Die Bonding GmbH, 8572 Berg TG (CH)
(72) Inventor: Buschmann, Daniel, 8280, Kreuzlingen (CH); Trinks, Joachim, 9230, Flawil (CH)

(57) **Abstract**

A tool tip interface, in particular a shank, for use with a handling tool configured to handle a planar object, in particular a semiconductor die, is presented which comprises: a machine side interface which comprises a vacuum supply connection; a tip side interface having a bottom side on which a support surface for a tool tip is formed and on which one or more depressions are formed so that the one or more depressions define support surface portions which are at least partially surrounded by depressed regions, wherein support surface portions and depressed regions are uniformly distributed over at least a central region of the bottom side of the tip side interface.

## Description

### Field of the Invention

The present invention pertains to the field of automation technology. It relates to a tool tip interface, in particular a shank, for use with a handling unit, in particular for a die bonder, configured to handle a planar object, in particular a semiconductor die, in accordance with the preamble of the independent patent claim.

### Background of the Invention

One of the biggest challenges in semiconductor packaging is picking, handling and mounting of very thin semiconductor chips. The semiconductor chips are generally provided on a carrier tape, which generally contains a whole semiconductor wafer that has been cut into small chips, a process frequently referred to as dicing. The semiconductor chips are thus commonly referred to as dies. The carrier tape is often the same tape that supported the wafer during dicing, often referred to as dicing tape. Die thicknesses of down to 25µm are common today, and there is an ongoing trend to decrease thicknesses even further.

Die bonders pick a single die from the carrier tape and place and subsequently attach the picked die onto a substrate or onto another die. In most situations, the die is attached permanently, but configurations where dies are only attached temporarily also exist. Often, a temporary attachment is subsequently turned into a permanent one by an additional heating and/or pressing process. Often, thin dies come with a wafer backside lamination (WBL) or film or flow over wire (FOW) lamination, i.e. an adhesive film which is applied to an unstructured side of the wafer or die. A process of thinning wafers, applying an adhesive film to the wafers, mounting the wafers to a carrier tape and frame, and dicing them into individual chips is usually referred to as wafer preparation. The lamination, which allows for the dies to be attached due to its adhesive properties, may be provided either between the carrier tape and the wafer, or on a surface of the wafer facing away from the carrier tape. The fabrication of very thin wafers and the corresponding dies is very expensive as compared to standard thickness wafers without lamination.

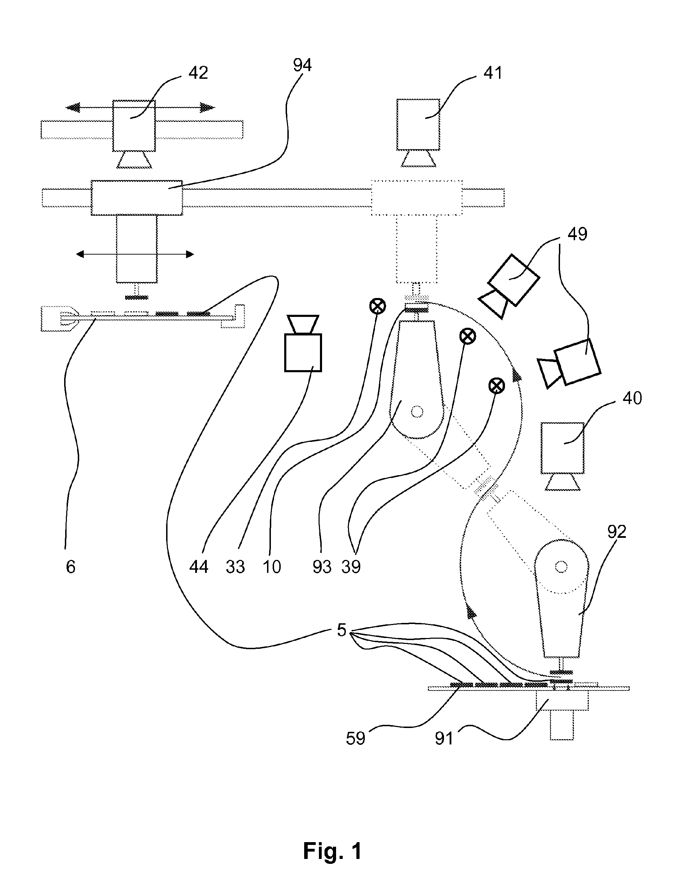

Picking and placing or attaching may be carried out by a single die handling unit in the die bonder. In modern die bonders, e.g. as shown in Fig. 1, a plurality of die handling units can be present: In general, picking takes place from a so called wafer table, and is assisted by a die ejector 91. The die ejector 91 facilitates the removal of the die 5 from the carrier tape 4, e.g. by pushing the die 5 against a first die handling unit called pick unit 92 - from underneath the carrier tape 4. The pick unit 92 subsequently picks the die 5 from the carrier tape 4 in a pick process. The die 5 is then handed over to a second die handling unit, also referred to as place unit 94. The place unit 94 places the die 5 onto a mounting location, where it is attached. In some cases, at least one third die handling unit - a so called transfer unit 93 - is provided to hand the die 5 from the pick unit 92 to the place unit 94. An example is given in WO 07118511 A1 which is hereby incorporated by reference in its entirety. In this manner, a die 5 may be attached to mounting location on a mounting surface of a substrate 6, e.g. a leadframe, printed circuit board, multilayer board etc., or of another die, which itself may be have been attached in the same way. A plurality of cameras 40, 41, 42, 44 is normally present for monitoring and/or measuring purposes.

Pick, place, and - if present - transfer unit each comprise a handling tool, which in turn comprises a work surface to which the die 5 becomes temporarily attached during handling, i.e. delivery to the target location of the respective handling unit. Temporary attachment is most frequently achieved by means of vacuum suction. The work surface is frequently formed on a region of a soft elastic material that acts as or forms part of a tool tip. Often, this is a rubber or silicone layer formed on an otherwise metallic handling tool. The presence of such a region of a soft elastic material helps to avoid chip damage, e.g. in situations where the pick, place or transfer tool is not perfectly aligned, so that the work surface and a surface of the die 5 that is to be contacted by the work surface are at an angle rather than parallel to one another. Generally, the tool tip comprises an essentially flat material section in which a plurality of through holes having first openings in the work surface are provided; and a back side from which vacuum may be supplied to the through holes.

In particular for thin dies, very strict requirements exist in relation to a number, shape, size, and/or spatial distribution of the through hole openings. These requirements vary with the type, dimensions and/or thickness of the dies to be handled, but also depend on the handling unit at which a specific tool tip is to be used. Due to manufacturing constraints, the requirements with regard to the through hole openings also relate to the trough holes themselves, and thus also influence position, shape and size of second openings that the trough holes form in the back side of the tool tip.

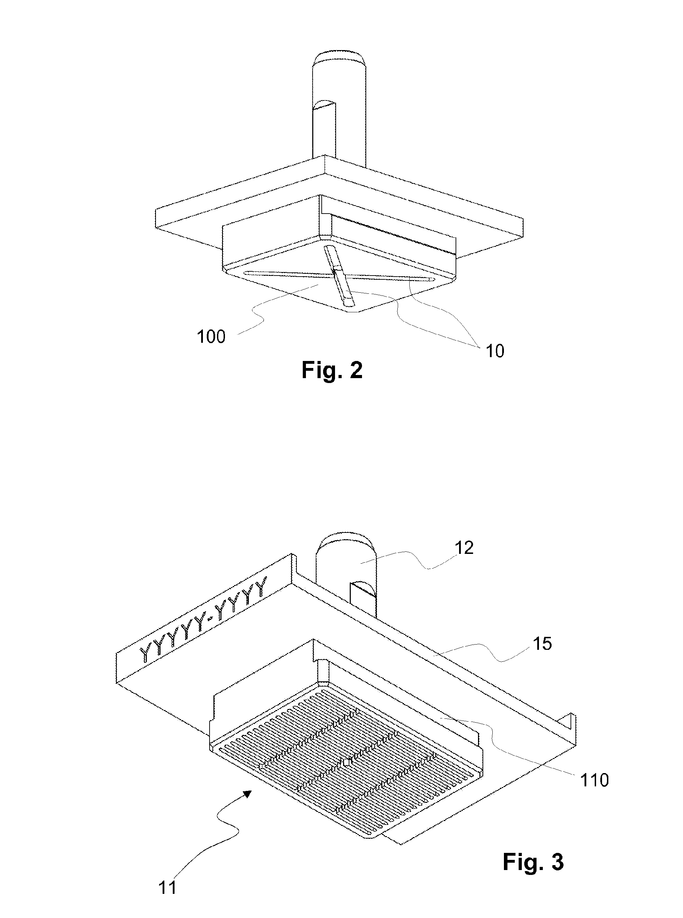

Frequently, the tool tip is formed exclusively from the soft elastic material and is detachably mounted to a tool tip interface, which is often provided in the form of a so-called shank. Fig. 2 shows a perspective view of a prior art shank. Generally, the tool tip comprises an essentially flat material section in which a plurality of through holes having openings in the work surface are provided; and a back side from which vacuum may be supplied to the through holes.

Known shanks consist of an essentially flat plate on a first side of which a hollow shaft is provided. A vacuum may be fed through the shaft to one or more vacuum channels 10 provided on a bottom side of the flat plate. To avoid unwanted deformations of the soft elastic material of the tool tip when mounted on the shank, the vacuum channels 10 are designed to cover as little of a surface of the bottom side as possible. This is achieved by making them as narrow as possible while still allowing for sufficient vacuum flow to securely fix dies 5 to the work surface. Also, they are designed to have minimum overall length, which often results in a star shaped arrangement around a small, central vacuum hole located in the center of the bottom side of the flat plate. Thus, a flat bearing surface 100 for the tool tip is formed that covers a major part of the bottom side of the flat plate, typically more than 90% or even 95%.

However, an approach as described above requires shanks having different design for each individual tool tip. Since usually a very large number of dies of varying dimensions are processed with a die bonder over the period of its lifetime, a similarly large number of shanks have to be acquired for each die handling unit. Since the shanks are precision parts, this significantly contributes to operation costs of a die bonder. In addition, changing from one tool tip to another tool tip having different parameters is complicated as it requires simultaneous exchange of the shank, which in turn may require recalibration of the respective die handling unit, leading to increased downtime. Also, tool tips may be mounted onto non-matching shanks, which may result in major process failures.

In addition, a heating element for heating the die 5 as required for many die bonding processes is often provided in the die handling unit and thus relatively far from the die 5 for cost efficiency and to avoid mounting and contact problems etc. that arise from a necessity of frequent exchange of shanks.

It is thus an object of the invention to provide a tool tip interface that overcomes the disadvantages described above.

### Summary of the invention

According to an exemplary embodiment of the present invention, a tool tip interface, in particular a shank, for use with a handling tool configured to handle a planar object, in particular a semiconductor die, comprises: a machine side interface which comprises a vacuum supply connection; a tip side interface having a bottom side on which a support surface for a tool tip (3) is formed and on which one or more depressions are formed so that the one or more depressions define support surface portions which are at least partially surrounded by depressed regions, wherein support surface portions and depressed regions are uniformly distributed over at least a central region of the bottom side of the tip side interface.

The aforementioned and further objectives, advantages and features of the invention will be detailed in the description of preferred embodiments below in combination with the drawings.

### Brief Description of the Drawings

The invention is best understood from the following detailed description when read in connection with the accompanying drawing. It is emphasized that, according to common practice, the various features of the drawing are not to scale. On the contrary, the dimensions of the various features are arbitrarily expanded or reduced for clarity. Included in the drawing are the following figures:
Fig. 1 shows a schematic representation of a die bonder.
Fig. 2 shows a perspective view of a prior art tool tip interface.
Fig. 3 shows a perspective view of a tool tip interface in accordance with the present invention.
Fig. 4 shows a top view of a bottom side of the tool tip interface from Fig. 3.
Fig. 5 shows a perspective view of a tool tip for use in connection with a tool tip interface 11 in accordance with the present invention.
Fig. 6 shows a different perspective view of the tool tip from Fig. 5.
Fig. 7 shows a perspective view of a tool tip interface in accordance with an alternative embodiment of the present invention.
Fig. 8 shows a top view of a bottom side of the tool tip interface from Fig. 7.

### Detailed Description of the Invention

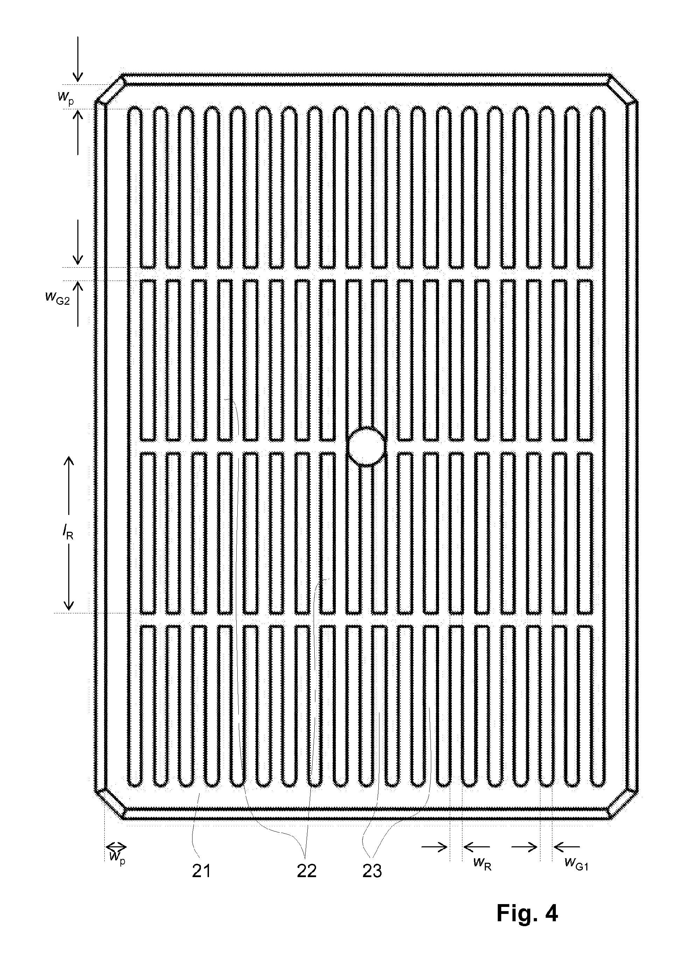

Fig. 3 shows a perspective view of a tool tip interface 11 in accordance with an exemplary embodiment of the present invention. The tool tip interface 11 is formed as an integrated part of a shank, which further comprises a hollow shaft 12 by means of which the shank my be mounted to a die handling unit, and which acts as machine side interface of the tool tip interface 11. On a bottom side of the tool tip interface 11, a support surface was formed by working an initially planar surface so that a grid shaped depression results, e.g. by means of engraving, milling, embossing, electro-abrasion, etc. Fig. 4 shows a top view of the bottom side of the tool tip interface 11. In the example shown in Figs. 3 and 4, the grid shaped depression consists of 19 grooves extending in a first direction, and 3 groves extending in a second direction perpendicular to the first direction. The grid shaped depression is formed in a central region of the bottom side of the tool tip interface 11, with grid dimensions chosen so that only a narrow peripheral region 21 of the bottom side remains where no grooves are formed.

A multitude of ridges 22, 23 thus results, which are surrounded by depressed regions. Isolated ridges 22 have rectangular planar surfaces which are surrounded by grooves on all sides. Contiguous ridges 23 are located adjacent to the peripheral region 21, and are surrounded by grooves on three sides. The contiguous ridges 23 also have planar surfaces. The planar surfaces of both the isolated and contiguous ridges 22, 23 form support surface portions of a planar central support surface for a tool tip 3, with all the support surface portions lying in one plane. A surface of the narrow peripheral region 21 is also located in that plane, and acts as a peripheral support surface. In the central region of the bottom side of the tool tip interface 11, both support surface portions and depressed regions are thus uniformly distributed.

In the exemplary embodiment shown, ridges 22, 23 as well as grooves extending in the first and second direction have uniform widths *w*_{R}, *w*_{G1} and *w*_{G2}, respectively, with *w*_{R} = *w*_{G1} = *w*_{G2}. As a consequence, a maximum distance *d*ₘₐₓ from any point on any of the ridges 22, 23 to the nearest depressed region is half the width of the ridges, i.e. *d*ₘₐₓ = *w*_{R}/2. The ridges 22, 23 have a uniform length *l*_{R}, so that a central support surface area of *A*_{s,c} = 18×4×*w*_{R}×*l*_{R} = 72*w*_{R}*l*_{R} results. A cross section area *A*_{d} of the depressed regions in the plane of the support surface, on the other hand, is approximately *A*_{d} ≈ 19×4×*w*_{G1}×*l*_{R} = 76*w*_{R}*l*_{R}, where a contribution of the grooves extending in the second direction has been neglected. The narrow peripheral region has a width w_{P} of approximately w_{P} ≈ 2*w*_{R}. For a bottom side aspect ratio of roughly 4:3 as in the exemplary tool tip interface 11 shown in Figs. 3 and 4, an approximate peripheral support surface area of *A*_{s,p} ≈ 2×2*w*_{R} × (4+3) *l*_{R} = 28*w*_{R}*l*_{R} results.

A carrier plate 15 for a heating element, e.g. a thin film of Al₂O₃ with electrical connections for applying a voltage, is also provided on the shank. Preferably, the carrier plate 15 and the bottom side of the tool tip interface 11 are made of a copper alloy to allow for efficient heating of a die attached to the work surface. By thus providing the heating element on the shank rather than within the handling unit, efficient heating with rapid changes in die temperature is possible.

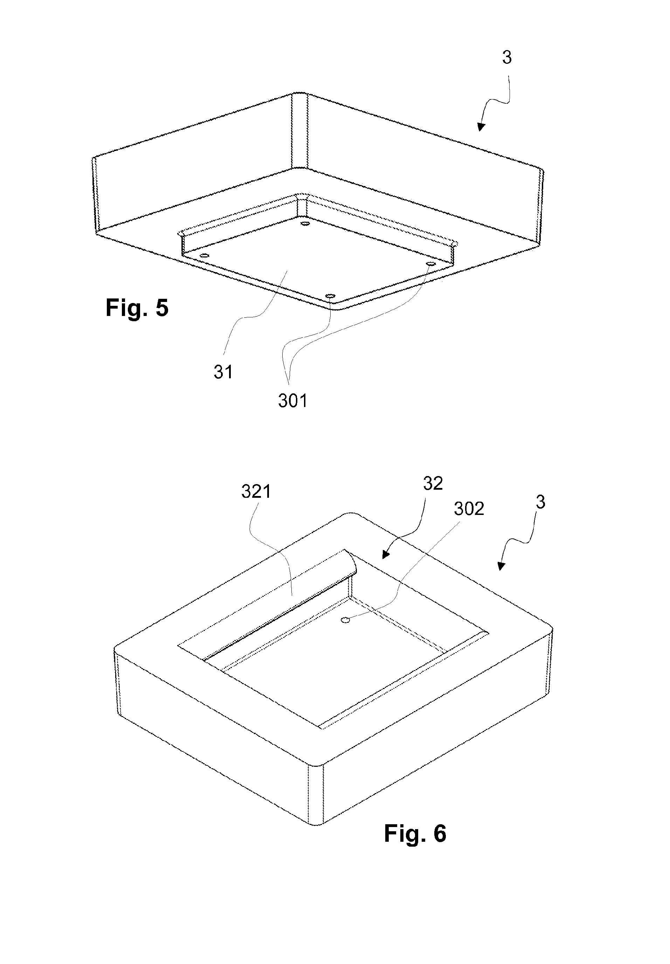

Figs. 5 and 6 show perspective views of a tool tip 3 for use in connection with a tool tip interface 11 in accordance with the present invention. The tool tip 3 is made of an elastomeric material, in particular a rubber, preferably a silicone rubber, and is essentially box-shaped. A rectangular work surface 31 is formed on a front side of the tool tip 3. A recession 32 provided on a back side of the tool tip 3 allows for mounting the tool tip 3 to the tool tip interface 11 by putting the tool tip 3 over the bottom side of the tool tip interface 11. The recession 32 preferably has a flat bottom, which will thus come in tight contact with the support surface of the tool tip interface 11. Lateral indentations 110 are provided near the bottom side of the tool tip interface 11, and may interact with protrusions 321 formed on an upper end of one or more side walls of the recession 32 to allow for tightly fixing the tool tip 3 to the tool tip interface 11. When the tool tip 3 is fixed to the tool tip interface 11, a handling tool for a die handling unit is obtained. The grooves formed on the bottom side of the tool tip interface 11 serve as first vacuum ducts and are connectable to a vacuum supply through the hollow shaft 12 of the shank, which is configured to be used as a vacuum supply connection.

A plurality of through holes is provided in the tool tip 3 to act as second vacuum ducts. The through holes form first through hole openings 301 and second through hole openings 302 on the front and back side of the tool tip 3, respectively. The second through hole openings 302 have a diameter *d*₂ which equals - at least approximately - twice the width *w*_{R} of the ridges 22, 23 of the tool tip interface 11. Preferably, each of the second through hole openings 302 is configured to satisfy the relation 1.2 *w_{R}* < *d*₂ < 3.5 *w*_{R}, preferably 1.5 *w*_{R} < *d*₂ < 2.5 *w*_{R}. By such a choice of relation between second through hole opening diameters and ridge width *w*_{R}, the second through hole openings 302 may be provided at arbitrary locations on the flat bottom of the recession 32. As long as *w*_{R} < *d*₂ is fulfilled, it is always guaranteed that the respective second through hole opening 302 may not be completely obstructed by a ridge 22, 23 upon which it may come to rest when the tool tip 3 is mounted to the tool tip interface 11. In this way, an unobstructed vacuum flow between the first and second vacuum ducts is ensured. Of course, through holes having second through hole openings 302 of non-circular shape may also be employed to advantage. In this case, an average width or average cross section length of the second through hole opening 302 needs to be taken for the value of the diameter *d*₂ in the above relations.

To further guarantee that vacuum ducts will never be obstructed independent of a location of the second through hole openings 302, the peripheral support surface area *A*_{s,p} is preferably chosen to be significantly smaller than a sum *A*_{s,c} + *A*_{d} of the central support surface area *A*_{s,c} and the cross section area *A*_{d} of the depressed regions. Advantageously, 3*A*_{s,p} < *A*_{s,c} + *A*_{d} holds, preferably 5*A*_{s,p} < *A*_{s,c} + *A*_{d}; and/or 2*A*_{s,p} < *A*_{s,c} and 2*A*_{s,p} < *A*_{d} is simultaneously fulfilled. Preferably 0.5*A*_{s,c} < *A*_{d} < 2*A*_{s,c} is also fulfilled, preferably 0.75*A*_{s,c} < *A*_{d} < *1.33A*_{s,c} or *A*_{d} ≈ *A*_{s,c}.

As a consequence of the possibility of providing second through hole openings 302 at arbitrary locations, tool tips 3 having varying work surface dimensions may be used on one and the same tool tip interface 11. A handling tool range is thus obtained, allowing for a handling unit to be quickly and easily adapted to handling of dies with varying dimensions by simply exchanging the tool tip 3. In particular, tool tips 3 may have a work surface of significantly smaller dimensions than a bottom side of the tool tip interface 11 and/or the sum *A*_{s,c} + *A*_{d} of the central support surface area *A*_{s,c} and the cross section area A_{d} of the depressed regions of the tool tip interface 11. Preferably, across section of the front side of such tool tips 3 exhibits a step profile.

For tool tips 3 having identical work surface dimensions, a number and/or spatial distribution of the second through hole openings 302 may also be varied. Even the diameter *d*₂ of the second through hole openings 302 may vary, as long as *w_{R}* < *d*₂ is fulfilled, where advantageously 1.2 *w_{R}* < *d*₂ < 3.5 *w*_{R}, preferably 1.5 *w*_{R} < *d*₂ < 2.5 *w*_{R} as detailed above. This way, identical tool tip interfaces 11 may be used with various die handling units within a die bonder. In particular, for a place unit, a use of tool tips 3 with relatively few and small first through hole openings 301, which are located on a peripheral region of the work surface 31, tend to show optimum process results with respects to a failure rate of bonded dies. For a pick unit, on the other hand, a relatively big number of uniformly distributed first through hole openings 301 is required to allow for stably picking of the dies 5 and reliably removing them from the carrier tape 6.

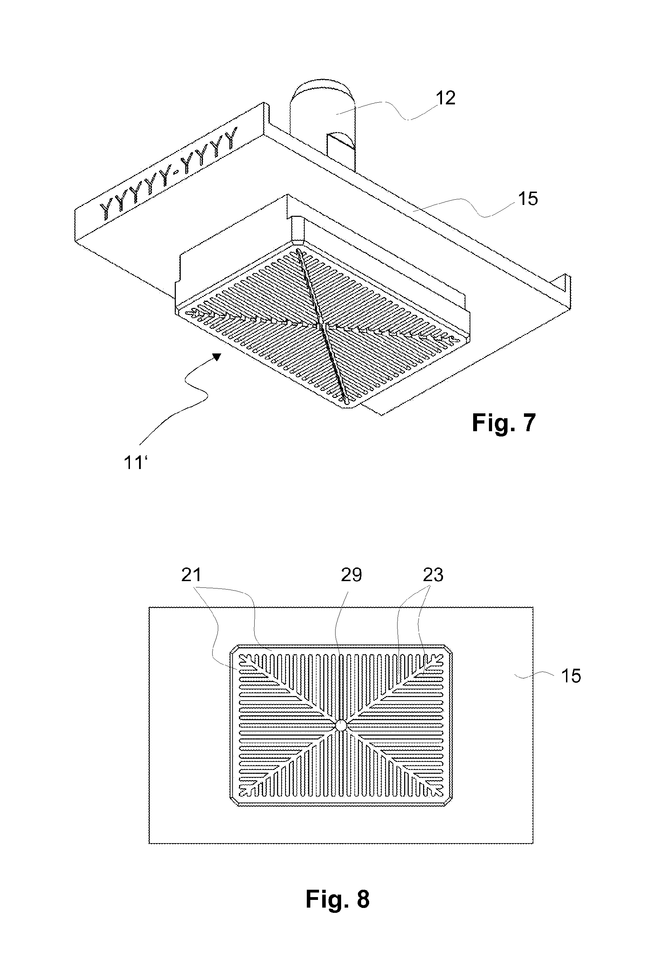

Fig. 7 and 8 show an alternative embodiment of a tool tip interface 11' in accordance with the present invention. In this embodiment, no isolated ridges exist. Only contiguous ridges 23 are present on the bottom side. Due to a presence of obtuse angles between grooves extending in first and second direction between the contiguous ridges 23 and diagonal grooves connecting the former to the central hole 29, an undisturbed vacuum flow is possible from depressed regions near the peripheral region 21 of the bottom side, allowing for rapid evacuation of the first vacuum ducts when a die is to be fixed to the work surface 31.

In the embodiments shown in Fig. 3, 4, 7 and 8, the peripheral region 21 forms a closed ring-shaped surface around the support surface portions and the depressed regions. Since the closed, ring-shaped surface lies in the plane of the support surface, it efficiently seals the depressed regions against an environmental atmosphere when a tool tip 3 is in placed on the tool tip interface 11, so that they may act as first vacuum ducts. However, if the recession 32 on the back side of the tool tip 3 is properly dimensioned to fit tightly over the tip side interface, efficient sealing can also be achieved with a non closed peripheral region, or even without a peripheral support surface, i.e. with *A*_{s,p} = 0. An absence of peripheral support surface, i.e. a choice of *A*_{s,p} = 0, allows for completely arbitrary location of the second through hole openings 302 in combination with the various relations related to their diameter *d*₂ detailed above.

While in the embodiments shown so far, the tool tip interface 11, 11' was formed as an integrated part of a shank, it may advantageously also be formed as a separate entity that may be reversibly attached either to a shank, which may in turn be attached to a die handling unit, or to a die handling unit directly. A suitable machine side interface using features known to a person skilled in the art may then allow for rigid mechanical connection, as well as for airtight connection of the vacuum supply connection to a vacuum supply comprised with the die bonder.

In another preferred embodiment of a tool tip interface in accordance with the present invention, the support surface portions are randomly distributed across the bottom side of the tool tip interface. A corresponding support surface can e.g. be obtained by smoothening of a rough surface e.g. by polishing to such an extent that elevations in a surface roughness profile exceeding a given altitude are removed. Depending on parameters characterizing the roughness profile, and by an extent of smoothening, a support surface will result that may be characterized by a maximum distance *d*ₘₐₓ between a point on any of the support surface portions and the nearest depressed region. The tool tip interface may then be used with tool tips 3 having second through hole openings 302 at arbitrary locations as long as the diameter *d*₂ of the second through hole openings 302 is larger than twice the maximum distance *d*ₘₐₓ, i.e. *d*₂ > 2*d*ₘₐₓ, where preferably 2.5 *d*ₘₐₓ < *d*₂ < 7 *d*ₘₐₓ, preferably 3 *d*ₘₐₓ < *d*₂ < 5 *d*ₘₐₓ.

In another preferred embodiment of a tool tip interface in accordance with the present invention, both the grooves and the support surface may also have the shape of a two-dimensional spiral with e.g. circular and/or rectangular windings. Each winding of the support surface can then be regarded as a support surface portion, which is surrounded by two windings of the groove.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. A tool tip interface (11, 11'), in particular a shank, for use with a handling tool configured to handle a planar object, in particular a semiconductor die (5), said tool tip interface (11, 11') comprising
a) a machine side interface which comprises a vacuum supply connection (12)
b) a tip side interface having a bottom side
i. on which a support surface for a tool tip (3) is formed and
ii. on which one or more depressions are formed
iii.so that the one or more depressions define support surface portions (22, 23) which are at least partially surrounded by depressed regions
**characterized in that**
c) support surface portions (22, 23) and depressed regions are uniformly distributed over at least a central region of the bottom side of the tip side interface.

2. The tool tip interface (11, 11') according to claim 1, wherein the support surface portions (22, 23) comprise a plurality of isolated ridges (22) formed on the bottom side of the tip side interface, and wherein said isolated ridges (22) have planar surfaces and are surrounded by depressed regions on all sides.

3. The tool tip interface (11, 11') according to one of the previous claims, wherein
a) the support surface portions (22, 23) formed in the central region of the bottom side of the tip side interface cover an area *A*_{s,c},
b) the depressed regions cover an area *A*_{d}, and wherein
c) 0.5*A*_{s,c} < *A*_{d} < 2*A*_{s,c}, preferably 0.75*A*_{s,c} < *A*_{d} < 1.33*A*_{s,c}, is fulfilled.

4. The tool tip interface (11, 11') according to one of the previous claims, wherein
a) the bottom side of the tip side interface comprises a peripheral region (21) where no depressed regions are formed, where
b) the peripheral region (21) covers an area *A*_{s,p}, and wherein
c) 3*A*_{s,p} < *A*_{s,c} + *A*_{d}, preferably 5*A*_{s,p} < *A*_{s,c} + *A*_{d} is fulfilled.

5. A tool tip interface (11, 11') according to one of the previous claims, **characterized in that** the tool tip interface (11, 11') is formed as an integrated part of a shank.

6. A tool tip interface (11, 11') according to one of claims 1 through 4, **characterized in that** the tool tip interface (11, 11') may be detachably mounted on a shank.

7. A handling tool for handling a planar object, in particular a semiconductor die (5), comprising,
a) a tool tip interface (11, 11') according to one of the previous claims
b) a tool tip (3) made of elastic material which my be temporarily attached to the tool tip interface (11, 11'), the tool tip (3) having
i. a front side on which a work surface (31) is formed to which the planar object may be temporarily attached by vacuum suction,
ii. a back side by which the tool tip (3) may be attached to bottom side of the tool tip interface (11, 11') so that
iii. the one or more depressions of the tool tip interface (11, 11') may serve as first vacuum ducts, which are connectable to a vacuum supply through the vacuum supply connection (12) of the tool tip interface (11, 11'); and wherein
c) said first vacuum ducts are in connection with second vacuum ducts provided between the work surface (31) and the back side of the tool tip (3) and form first openings (301) in the work surface and second openings (302) on the back side.

8. The handling tool according to claim 7, wherein a diameter or average width *d*₂ of the second openings (302) is at least twice as large as a maximum distance *d*ₘₐₓ between an arbitrary point on any of the support surface portions (22, 23) and the depressed region nearest to that point, i.e. *d*₂ > 2*d*ₘₐₓ.

9. The handling tool according to claim 7 or 8, having a tool tip (3) with a recession (32) formed on the back side of said tool tip (3) so that the tool tip (3) may be put over the bottom side of the tool tip interface (11, 11').

10. A handling tool range comprising a plurality of handling tools according to claims 7 through 9, having one common tool tip interface (11, 11') and a plurality of tool tips (3) with second vacuum ducts having second openings (302) on the back side of the tool tip (3), whereas for each tool tip (3) the second openings (302) have different locations.

11. A die bonder comprising two or more die handling units, wherein at least two of said die handling units are equipped with a handling tool according to one of the claims 7 through 9.

12. The die bonder according to claim 11, wherein the at least two handling units are equipped with identical tool tip interfaces (11, 11').
